(19) Europäisches Patentamt

European Patent Office

Office européen des brevets

(11) **EP 1 452 851 A1**

(12) **EUROPEAN PATENT APPLICATION**

(43) Date of publication:
**01.09.2004 Bulletin 2004/36**

(51) Int Cl.⁷: **G01N 21/15**, G01M 11/00, G03F 7/20

(21) Application number: **04075557.1**

(22) Date of filing: **20.02.2004**

(84) Designated Contracting States:
**AT BE BG CH CY CZ DE DK EE ES FI FR GB GR HU IE IT LI LU MC NL PT RO SE SI SK TR**
Designated Extension States:
**AL LT LV MK**

(30) Priority: **24.02.2003 EP 03075548**

(71) Applicants:
• **ASML Netherlands B.V.**
  **5503 LA Veldhoven (NL)**
• **CARL ZEISS SEMICONDUCTOR MANUFACTURING TECHNOLOGIES AG**
  **73447 Oberkochen (DE)**

(72) Inventors:
• **Kurt, Ralph**
  **5655 CG Eindhoven (NL)**
• **van Beek, Michael Cornelis**
  **5646 HX Eindhoven (NL)**

• **Duisterwinkel, Antonie Ellert**
  **2612 EC Delft (NL)**
• **Kieft, Erik René**
  **5631 KK Eindhoven (NL)**
• **Meiling, Hans**
  **5581 GL Waalre (NL)**
• **Mertens, Bastiaan Matthias**
  **2517 RK Den Haag (NL)**
• **Moors, Johannes Hubertus Josephina**
  **5709 MT Helmond (NL)**
• **Stevens, Lucas Henricus Johannes**
  **5658 EE Eindhoven (NL)**
• **Wolschrijn, Bastiaan Theodoor**
  **1059 AM Amsterdam (NL)**

(74) Representative:
**Prins, Adrianus Willem, Mr. Ir. et al**
**Vereenigde,**
**Nieuwe Parklaan 97**
**2587 BN Den Haag (NL)**

(54) **Method and device for measuring contamination of a surface of a component of a lithographic apparatus**

(57)    A measuring device for determining contamination of a surface of a component in an lithographic projection apparatus. The measuring device has a radiation transmitter device for projecting radiation on at least a part of said surface and a radiation receiver device for receiving radiation from the component. A processor device is communicatively connected to the radiation receiver device, for deriving a property of received radiation and deriving a property of the contamination from this property of radiation.

Also a method for measuring properties of contamination of a surface of a component in a lithographic projection apparatus, comprising: projecting radiation on the surface; receiving radiation from the component and deriving from the received radiation properties of the contamination

Fig. 3

EP 1 452 851 A1

**Description**

FIELD AND BACKGROUND OF THE INVENTION

The present invention relates to a method for measuring contamination of a surface of a component in a lithographic projection apparatus. The invention also relates to a lithographic projection apparatus. The invention further relates to a device manufacturing method and a computer program product.

The term "patterning means" as here employed should be broadly interpreted as referring to means that can be used to endow an incoming radiation beam with a patterned cross-section, corresponding to a pattern that is to be created in a target portion of a substrate; the term "light valve" can also be used in this context. Generally, the said pattern will correspond to a particular functional layer in a device being created in the target portion, such as an integrated circuit or other device (see below). Examples of such patterning means include:

- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, its corresponding support structure will generally be a mask table, which ensures that the mask can be held at a desired position in the incoming radiation beam, and that it can be moved relative to the beam if so desired;

- A programmable mirror array. One example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-adressable surface. An alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-adressable mirrors. The required matrix addressing can be performed using suitable electronic means. In both of the situations described hereabove, the patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096, which are incorporated herein by reference. In the case of a programmable mirror array, the said support structure may be embodied as a frame or table, for example, which may be fixed or movable as required; and

- A programmable LCD array. An example of such a construction is given in United States Patent US 5,229,872, which is incorporated herein by reference. As above, the support structure in this case may be embodied as a frame or table, for example, which may be fixed or movable as required.

For purposes of simplicity, the rest of this text may, at certain locations, specifically direct itself to examples involving a mask and mask table; however, the general principles discussed in such instances should be seen in the broader context of the patterning means as hereabove set forth.

Lithographic projection apparatus may be used, for example, in the manufacture of integrated circuits (ICs). In such a case, the patterning means may generate a circuit pattern corresponding to an individual layer of the IC, and this pattern may be imaged onto a target portion (e.g. comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction may be made between two different types of machine. In one type of lithographic projection apparatus, each target portion is irradiated by exposing the entire mask pattern onto the target portion in one go; such an apparatus is commonly referred to as a wafer stepper or step-and-repeat apparatus. In an alternative apparatus, commonly referred to as a step-and-scan apparatus, each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792, incorporated herein by reference.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices may be mounted on a carrier, connected to pins, etc. Further information regarding such processes may be obtained, for example, from the book "Microchip Fabrication: A Practical Guide to Semiconductor Processing", Third Edition, by Peter van Zant, McGraw Hill Publishing Co., 1997, ISBN 0-07-067250-4, incorporated herein by reference.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791, both incorporated herein by reference.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, or otherwise. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet (UV) radiation (e.g. with a wavelength of 365, 248, 193, 157 or 126 nm) and extreme ultra-violet (EUV) radiation (e.g. having a wavelength in the range 5-20 nm), as well as particle beams, such as ion beams or electron beams.

In general, the surfaces of components of a lithographic projection apparatus get contaminated during use, for example because of hydrocarbon molecules which are always present in the apparatus, even if most of the apparatus is operated in vacuum. It should be noted that in general an EUV lithographic projection apparatus is a closed vacuum system. Contamination may also be caused by other materials, such as, but not limited to, reactants from radiation induced cracking of hexa-methyl disilazane or other silicon containing materials, for example oxides of silicon. Especially in an apparatus using DUV or EUV, the components may suffer from contamination by carbon-containing materials due to radiation induced cracking of hydrocarbon molecules.

In particular the contamination of optical components in the lithographic projection apparatus, such as mirrors, has an adverse effect on the performance of the apparatus because such contamination affects the optical properties of the optical components. Contamination of optical components, for example, results in heating of the components due to increased absorption of radiation; causes losses in reflectivity and transparency, and introduces wavefront errors. This results in short lifetimes of the optics. Contamination of the optical components is especially a problem when using EUV radiation, since the radiation induced contamination, e.g. of carbon, will occur for a large part in the irradiated area, i.e. near the optical components.

Thus, control and knowledge of the contamination is desired.

SUMMARY OF THE INVENTION

It is general object of the present invention to provide a method for measuring contamination of a surface of a component in a lithographic projection apparatus. The invention therefore provides a method according to claim 1.

By such a method at least one property of the contamination can be measured because the received radiation is at least partly dependent on the contamination.

The invention further provides a lithographic projection apparatus according to claim 24. According to a further aspect of the invention a device manufacturing method according to claim 25 is provided. Furthermore, the invention provides a computer program product as claimed in claim 26. Such apparatus, method and program allow measuring a property of contamination of a surface in a lithographic projection apparatus.

Specific embodiments of the invention are set forth in the dependent claims. Further details, aspects and embodiments of the invention will be described, by way of example only, with reference to the attached drawing.

<u>BRIEF DESCRIPTION OF THE DRAWINGS</u>

FIG. 1 schematically shows an example of an embodiment of a lithographic projection apparatus according to invention.

FIG. 2. shows a side view of an example of an embodiment of a EUV illuminating system and projection optics of an example of an embodiment of a lithographic projection apparatus according to the invention.

FIG. 3 schematically shows a first example of an embodiment of a measuring device according to the invention.

FIG. 4 schematically shows a second example of an embodiment of a measuring device according to the invention.

FIG. 5 schematically shows a third example of an embodiment of a measuring device according to the invention.

FIG. 6 shows experimental results of relative reflectivity of an EUV mirror contaminated with a carbon layer of varying thickness.

FIGs. 7A and 7B show graphs of the reflectivity as a function of electromagnetic radiation wavelength of two types of multi-layer mirrors with and without contamination by a layer of carbon.

FIGs. 8A and 8B show graphs of a simulation of the reflectivity of a multi-layer mirror surface as a function of wavelength for contamination with carbon or silicon-oxide layers of different thickness.

FIG. 9 schematically shows a block diagram of a section of a processor device which can be used in the examples of FIGs. 3-5.

FIG. 10 shows a graph of a simulation of the reflectivity of a multi-layer mirror surface as a function of carbon contamination thickness for different angles of incidence of radiation from an infrared laser.

<u>DETAILED DESCRIPTION</u>

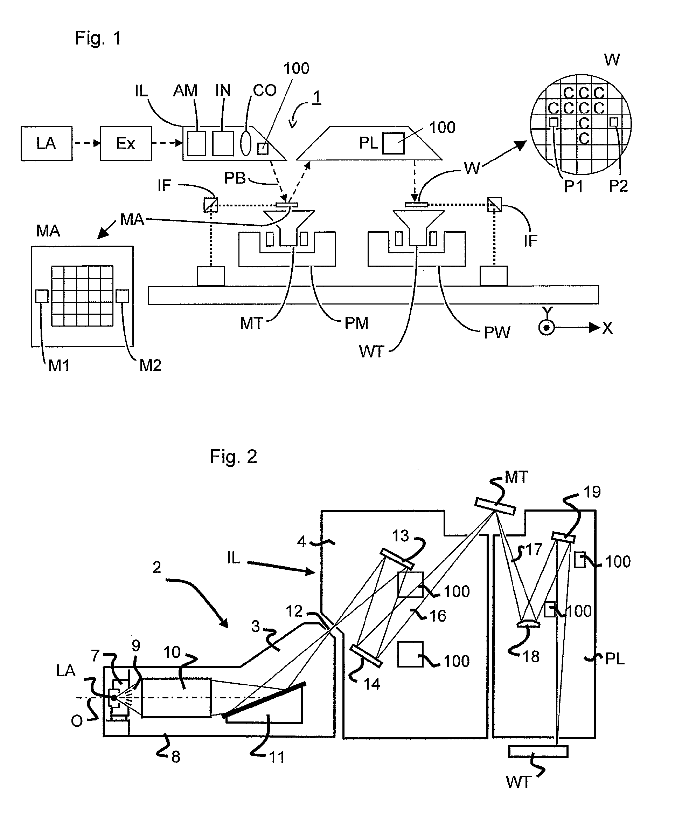

FIG. 1 schematically depicts an example of an embodiment of a lithographic projection apparatus 1 according to the invention. The lithographic projection apparatus 1 typically comprises a radiation system Ex, IL, for supplying a projection beam PB of radiation (e.g. UV or EUV radiation). In this particular case, the radiation system also comprises a radiation source LA; a first object table (mask table) MT provided with a mask holder for holding a mask MA (e.g. a reticle), and connected to first positioning means PM for accurately positioning the mask with respect to item PL; a second object table WT provided with a substrate holder for holding a substrate W (e.g. a resist-coated silicon wafer), and connected to second positioning means PW for accurately positioning the substrate with respect to item PL; and a projection system ("lens") PL (e.g. a mirror group) for imaging an irradiated portion of the mask MA onto a target portion C (e.g. comprising one or more dies) of the substrate W.

As here depicted, the apparatus is of a reflective type (i.e. has a reflective mask). However, in general, it may also be of a transmissive type, for example (with a transmissive mask). Alternatively, the apparatus may employ another kind of patterning means, such as a programmable mirror array of a type as referred to above.

The source LA (e.g. a Hg lamp, an excimer laser, an undulator or wiggler provided around the path of an electron beam in a storage ring or synchronotron, a laser produced plasma or otherwise) produces a beam of radiation, in this example Extreme Ultra Violet radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as $\sigma$-outer and $\sigma$-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to FIG. 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. The current invention and claims encompass both of these scenarios.

The beam PB subsequently intercepts the mask MA, which is held on a mask table MT. Having been reflected by the mask MA, the beam PB passes through the projection system PL, which focuses the beam PB onto a target portion C of the substrate W. With the aid of the second positioning means PW (and interferometric measuring means IF), the substrate table WT can be moved accurately, e.g. so as to position different target portions C in the path of the beam PB. Similarly, the first positioning means PM can be used to accurately position the mask MA with respect to the path of the beam PB, e.g. after mechanical retrieval of the mask MA from a mask library, or during a scan. In general, movement of the object tables MT, WT will be realized with the aid of a long-stroke module (coarse positioning) and a short-stroke module (fine positioning), which are not explicitly depicted in FIG. 1. However, in the case of a wafer stepper (as opposed to a step-and-scan apparatus) the mask table MT may just be connected to a short stroke actuator, or may be fixed. Mask MA and substrate W may be aligned using mask alignment marks M1, M2 and substrate alignment marks P1, P2.

The depicted apparatus can be used in two different modes:

1. In step mode, the mask table MT is kept essentially stationary, and an entire mask image is projected in one go (i.e. a single "flash") onto a target portion C. The substrate table WT is then shifted in the x and/or y directions so that a different target portion C can be irradiated by the beam PB; and

2. In scan mode, essentially the same scenario applies, except that a given target portion C is not exposed in a single "flash". Instead, the mask table MT is movable in a given direction (the so-called "scan direction", e.g. the y direction) with a speed v, so that the projection beam PB is caused to scan over a mask image; concurrently, the substrate table WT is simultaneously moved in the same or opposite direction at a speed $V = Mv$, in which M is the magnification of the lens PL (typically, $M = 1/4$ or $1/5$). In this manner, a relatively large target portion C can be exposed, without having to compromise on resolution.

FIG. 2 shows an example of a projection optics system PL and an example of a radiation system 2 which can be used in the example of a lithographic projection apparatus 1 of FIG. 1. The radiation system 2 comprises an illumination system IL with an illumination optics unit 4. The radiation system 2 may also comprise a source-collector module or radiation unit 3 . The radiation unit 3 is provided with a radiation source LA which may for example be formed by a discharge plasma, a laser produced plasma or otherwise. The radiation source LA may employ a gas or vapor, such as Xe gas or Li vapor in which a very hot plasma may be created to emit radiation in the EUV range of the electromagnetic spectrum. The very hot plasma is created by causing a partially ionized plasma of an electrical discharge to collapse onto the optical axis O. However, the very hot plasma may likewise be created by collapse onto a different axis. Partial pressures of 0.1 mbar of Xe gas, Li vapor or any other suitable gas or vapor may be required for efficient generation of the radiation. The radiation emitted by radiation source LA is passed from the source chamber 7 into collector chamber 8 via a gas barrier structure or "foil trap" 9. The gas barrier structure comprises a channel structure such as, for instance, described in detail in European patent applications EP-A-1 233 468 and EP-A-1 057 079, which are incorporated herein by reference.

The collector chamber 8 comprises a radiation collector 10 which according to the present invention is formed by a grazing incidence collector. Radiation passed by collector 10 is reflected off a grating spectral filter 11 to be focused in a virtual source point 12 at an aperture in the collector chamber 8. From chamber 8, the projection beam 16 is reflected in the illumination optics unit 4 via normal incidence reflectors 13, 14 onto a reticle or mask positioned on a reticle or mask table MT. A patterned beam 17 is formed which is imaged in the projection optics system PL via reflective elements 18, 19 onto a wafer stage or substrate table WT. More elements than shown may generally be present in the illumination optics unit 4 and the projection system PL.

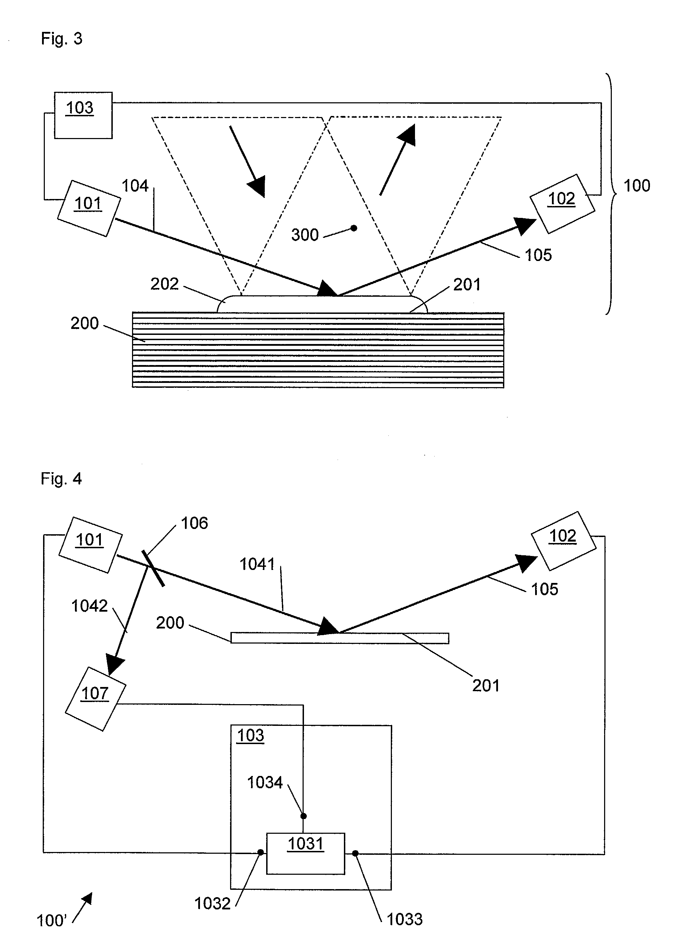

As is illustrated in FIGs. 1 and 2, the lithographic project apparatus 1 has examples of measurement devices 100 according to the present invention. The measurement device 100 can monitor a part of a surface in the lens PL and measure one ore more properties of the contamination of the surface. As shown in more detail in FIG.3, the measurement device 100 comprises a radiation transmitter device 101 and a radiation receiver device 102. The measuring device 100 further has a processor device 103 communicatively connected to the radiation receiver device 102.

In FIG. 3, the radiation transmitter device 101 can irradiate at least a part of a surface 201 of a component 200 in the lens PL with radiation 104. In FIG. 3, the surface 201 is contaminated with a layer 202 of contaminating material. The radiation receiver device 102 can receive radiation 105 from the surface 201 and the processor device 103 can determine a property of the contamination layer 202 from the received radiation. The projected radiation is modulated in one or more aspects by the surface or the contamination and thus the received radiation received at the receiver is a modulated radiation. The modulated aspects may for example be the (relative) intensity of the radiation, scattering of the radiation, direction in which the radiation is reflected, phase or polarization of the radiation or other properties of the radiation, such as the coherence of the radiation, for example and the invention is not limited to a specific aspect.

As an example, the component in FIG. 3 is a multi-layer mirror 200. However, the component may likewise be any other component in a lithographic projection apparatus, such as for example a mask, a grazing incidence mirror, a DUV lens, a sensor or otherwise. The multi-layer mirror 200 is especially suited for Extreme Ultraviolet (EUV) lithographic projection. For the sake of brevity, the multi-layer mirror and the projecting system are not described in further detail, as multi-layer mirrors are generally known in the art of lithographic projecting, for example from United States patent No. 6,410,928 incorporated herein by reference. Projecting systems with multi-layer mirrors are also generally known in the art of lithographic projecting, for example from the International patent publication WO 2002/056114, which is incorporated herein by reference.

As is shown in FIG. 3, EUV radiation 300 is projected on the multi-layer mirror 200. The projected radiation 300 is reflected by the mirror 200 as well. Typically, the angle of incidence of the radiation is close to normal incidence and around 84 degrees from grazing incidence. At the part of the surface 201 which is exposed to the EUV radiation, growth of a thin C film ( layer 202) is induced due to radiation induced cracking of carbohydrates. Thus, the contamination is supposed to be of a carbon containing material in this example. However, the contamination may likewise comprise different constituents, such as for example materials containing silicon or silicon-oxide or other oxides or otherwise, resulting for example from radiation induced cracking of photo-resists or otherwise.

The contamination may for example likewise comprise salt formations grown on the surface, such as dendrite salt structures. Without being bound to theory, the origin of such salt structures appears to be refractory compounds being present at very low concentrations (in the range of some parts per million to some parts per billion) in the purge air and is even found in purified nitrogen used for special purging purposes. Irradiation induced chemical (surface) reactions of silanes, sulfates or phosphates in combination with the presence of other gaseous contaminants such as oxygen, water, ammonia etc. are considered to be the basic degradation mechanism. It is commonly believed that nucleation as well as growth of the contaminating crystals occur only during exposure with radiation of G- and I-line and deep-UV wavelength.

The processor device 103 can determine one or more properties of the radiation received by receiver device 102 and derive from the properties of the radiation one or more properties of the contamination. The processor may for example determine a (relative) amount of received radiation, scattering of the radiation, direction in which the radiation is reflected, phase or polarization of the radiation or other properties of the radiation, such as the coherence of the radiation, for example.

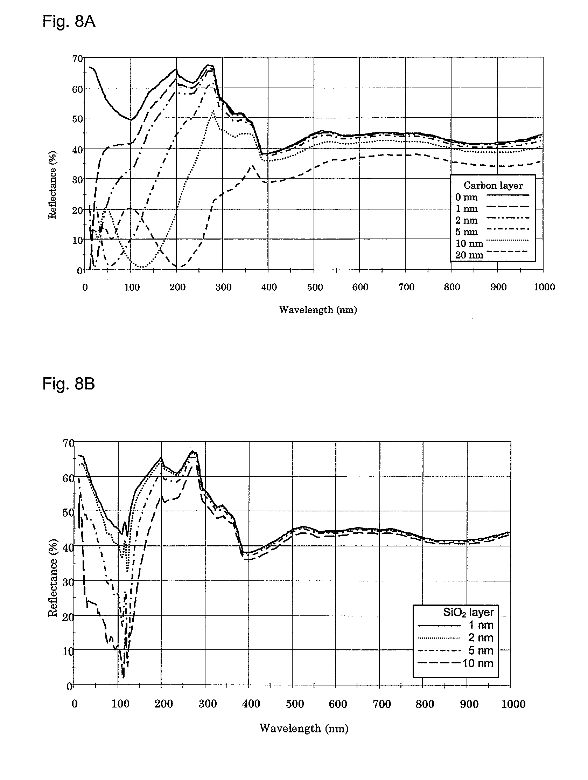

The properties of the contamination may for example be the thickness of the contamination, the materials present in the contamination or otherwise. The thickness may for example be determined from the ratio of the intensity of the radiation transmitted by the radiation transmitter device 101 and the intensity of the radiation received by the radiation receiver device 102. Likewise, the processor device may compare the spectra of the transmitted radiation and the received radiation with each other and derive from this comparison types of materials present in the radiation, as is described in more detail with reference to FIGs. 8A and 8B.

The processor device 103 may also compare a value of the determined property with a reference value. The processor device 103 may for example compare the determined thickness with a predetermined value for the maximum allowed thickness and output a signal if the determined thickness exceeds the predetermined value. Thus, an automatic contamination detection can be obtained and for instance an operator of the apparatus may be warned that the surface 201, and optionally other parts of the apparatus, needs to be cleaned. The processor device 103 may likewise determine that the surface is cleaned to a sufficient degree and automatically stop the cleaning to prevent overcleaning. A cleaning method or cleaning device may be used as described in the European patent application 02080488.6, which patent application is incorporated herein by reference.

In FIG. 4 a second example of a measurement device 100' is shown, which device comprises a radiation transmitter device 101, a first radiation receiver device 102, a second radiation receiver device 107 and a processor device 103. The radiation from the radiation transmitter device 101 is split by a beam splitter 106 in a first radiation beam 1041 and a second beam of radiation 1042. The first radiation beam 1041 is projected on the surface 201 of the component 200 and reflected by the surface 201 to the first radiation receiver device 102. The second radiation beam 1042 is directed from the beam splitter to the second radiation receiver 107.

The processor device 103 compares a signal representing the radiation received with the first radiation receiver device 102 with a signal representing the radiation received from the second radiation receiver device 107 and determines a property of the contamination, e.g. thickness, from the ratio of these received radiations. Thereby, the measuring is insensitive to fluctuations of the radiation emitted by the transmitter 101, such as changes in the intensity or wavelength, since the ratio is relatively independent of the actual value of the intensity or wavelength. A power supply with a high output stability may be used to supply the transmitter device and/or the other devices in a measuring device according to the invention. Thereby, fluctuations in the transmitted radiation are reduced and even small difference between the transmitted and received radiation can be determined, thus achieving a high sensitivity even for very thin layers.

A measuring device according to the invention may use radiation which is kept substantially constant over time. However the measuring device may likewise use radiation which changes over time, for example radiation which varies in intensity or wavelength in time. The measuring device may for example be a heterodyne measuring device. In general, in heterodyne methods or devices a signal is mixed with a signal of a different frequency and via a suitable reverse mixing process the original signal can be obtained. Heterodyne detection techniques are generally known in the art of signal processing and for the sake of brevity are not described in full detail.

Such a heterodyne measuring device may for example be implemented as in FIG. 4, in which example the radiation transmitter device 101 is a modulated radiation transmitter device outputting radiation with a temporally modulated varying amplitude. The modulation may be obtained for example by varying the power supplied to the transmitter, using a chopper or an electro-optical modulator or otherwise. In FIG. 4, the processor device 103 comprises a lock-in amplifier 1031, which is generally known in the art of electronics and for the sake of brevity will not be described in detail. The lock-in amplifier 1031 has a reference input 1032 communicatively connected to the radiation transmitter device 101 and signal inputs 1033,1034 communicatively connected to the first and second radiation receiver devices 102, 107 resp., and may be provided in the processor device 103 which compares the radiation received with the receiver device. The amplifier 1031 further has an output which is not shown in FIG. 4. The output is communicatively connected to other components in the processor device 103. Filtered signals are presented at the output of the lock-in amplifier 1031 which represents the radiation received at the respective radiation receiver device corrected for the modulation and may be processed further in the processor device 103 to determine one or more properties of the contamination, such as thickness, position of the contamination or otherwise.

A heterodyne measuring device according to the invention has an enhanced sensitivity compared to a non-heterodyne measuring device, which enhanced sensitivity may for example be about an order of magnitude higher. Furthermore, a heterodyne measuring device according to the invention is relatively non-sensitive to background radiation, such as scattered light.

In a lithographic apparatus according to the present invention having two or more measuring devices according to the invention, the radiation may be varied differently for each measuring device, thus reducing cross-talk between different measuring devices. For example, if two or more measuring devices according to the invention are used, each device may have a unique modulation frequency. Furthermore, radiation of different wavelengths can be used. Such differences, e.g. in the modulation frequency, may also be applied locally. For example, a single measuring device may measure two or more components each illuminated with radiation modulated with a different frequency, whereby each component may be monitored separately. In a similar manner, a measuring device may measure different portions of the surface of a single component with differently modulated radiation.

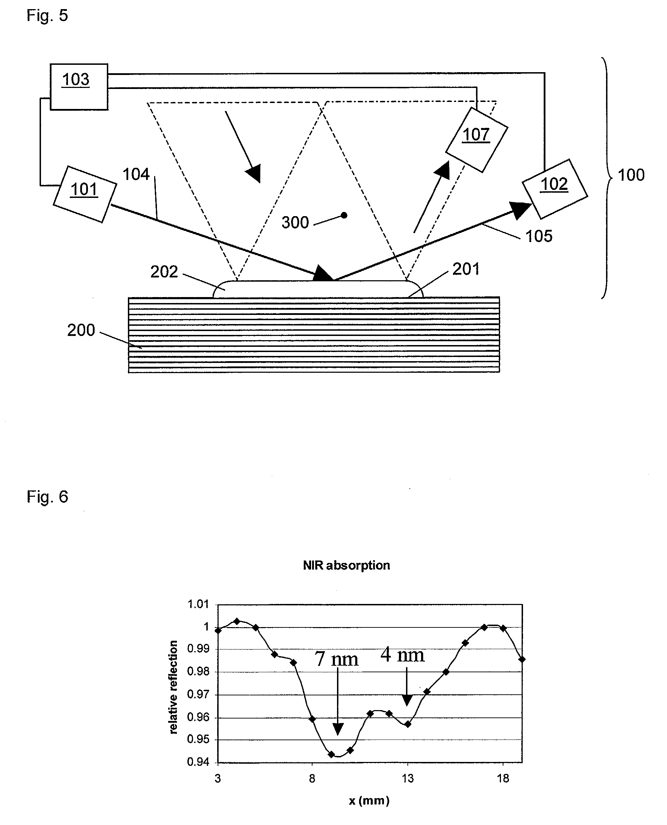

A measuring device according to the invention may be implemented in any manner suitable for the specific application. A measuring device may for example have one or more radiation transmitter devices and/or one or more radiation receiver devices. The transmitter and receiver devices may be similar or differing from each other, for example two transmitters providing different types of radiation can be used together with suitable receivers. The radiation transmitter device may for example include an InGaAs-laserdiode as often applied in optical telecommunication network systems, which diodes in general operate with a wavelength around 1,5 micrometer, and mostly about 1530 nm. Such a radiation transmitter device is relatively simple and inexpensive. The radiation receiver device may for example include a photodiode suitable for receiving the specific radiation or otherwise. The transmitter may also be a part of the projecting system of the apparatus, the radiation source LA of the example of FIG. 1 may for instance be used as a transmitter device in a measuring device according to the invention, as is shown in the example of FIG. 5.

The example of a measuring device according to the invention of FIG. 5, has two radiation receiver devices 102, 107 of which one radiation receiver device 102 can receive radiation from the transmitter device 101 and the other receiver device 107 can receive radiation 300 from the radiation source LA. In this example, the radiation source LA emits DUV or EUV radiation while the transmitter device 101 transmits optical radiation outside the DUV or EUV range. Thus, the receiver devices 102, 107 measure different properties of radiation reflected by the surface, i.e. different wavelengths of the reflected radiation. In the example of FIG. 5, it is assumed that both the radiation from the transmitter 101 and the radiation source LA are more or less monochromatic. However, it is likewise possible to use a transmitter device which transmits radiation with different wavelengths and to receive the radiation with two or more suitable receiver devices, each device sensitive to radiation of a different wavelength.

In a device or method according to the invention, the radiation may for example be electromagnetic radiation in visible, near infra red (NIR), infrared (IR) or far infrared (FIR) range. The radiation may be generated by a laser device or a broadband light source. Radiation in these ranges is especially suited to determine the thickness of contamination with carbon-containing materials. Carbon containing materials absorbs light in these ranges, thus contamination with carbon containing materials results in a loss of reflection and can be detected accurately. Furthermore, laser light is collimated, monochromatic, non-destructive, and measurable with high resolution.

In the examples of FIGs. 3 and 4, radiation reflected by the surface is detected by the radiation receiver device. Thereby, the measurement device has a high sensitivity since the light travels through the contamination layer twice. In the examples of FIGs 3 and 4 , the transmitter and the receiver are positioned on the same side of the component, e.g. above the surface (it is likewise possible to position the transmitter device and the receiver device below the surface) . However, it is likewise possible to measure a property of contamination from light transmitted through the surface, for example measure the thickness of the contamination layer by a change in intensity of the transmitted light. Thereby, the amount of contamination on non-reflective surfaces or transparent substrates may be measured as well. The transmitter device and the detector or radiation receiver device can then be positioned on different sides, for example the detector may be below the surface and the transmitter may be above the surface or vice versa.

In general, in an apparatus according to the invention an on-line analysis of contamination, i.e. without switching the apparatus off, is possible because a measurement device or method according to the invention does not interfere with the functionality of the optical system in the apparatus. Furthermore, when the radiation is laser light the radiation may for example be transmitted from a laser source outside the optical system or at a distance of the optical component and be directed to the surface via an optical fibre, to minimise the components of the measuring device according to the invention in the optical system.

In case optical radiation is used, the radiation transmitter device may comprise a low power laser diode to prevent an additional heat load. Heating may also be prevented by projecting the radiation of the radiation transmitter device on a large area of the surface, resulting in a low amount of radiation power per surface area. Also, a short measurement time may be used to overcome that problem. It was found that for the measurement of carbon growth a measurement rate of equal or below 1 measurement per min with optical radiation in the (near) infrared range is sufficient to monitor the contamination process with a large degree of accuracy. However, the invention is not limited to such measurement rate and any suitable measurement may be used. The measurement rate may likewise be varied. For example, two or more different measurement rates may be used. For instance, during a standard operation of lithographic projection apparatus, a first measurement rate may be used, and for example during a cleaning or (directly after) maintenance of the apparatus a second measurement rate is used. The second rate may for example be higher than the first measurement rate. For example, the first measurement rate may be around one measurement per minute and the second measurement rate may be (semi) continuous or otherwise.

A measurement device or method according to the invention may be used for determining local differences in the contamination, for example by irradiating with the radiation transmitter device 101 various parts of the surface. Different parts can be irradiated for example by moving the transmitter with respect to the surface or by scanning a beam of radiation along the surface for example using one or more mirrors. In the case that the device irradiate various parts of the surface, means may be provided to direct the radiation beam to a plurality of positions. Suitable means to achieve this may keep the surface fixed and deflecting the measurement beam or move the radiation transmitter with respect to the surface, keeping the measurement beam and moving the surface, using a plurality of measurement beams or otherwise.

FIG. 6 shows experimental results of the relative reflectivity in the near infrared (NIR) region along a surface contaminated with a layer of carbon with a varying thickness. In the experiments illustrated with the graph of FIG. 6, radiation of 780 nm wavelength was projected using a diode-laser, and the reflection at 45° angle of incidence of an EUV mirror with a carbon layer ranging from 4 to 7 nm thickness was measured. In this experiment the reflected beam was directly measured, i.e. no heterodyne detection. For the carbon layer, the absorption ranges from 4 to 6%, with respect to the reflection at an area without a carbon layer. For this arrangement a maximum absorption was found at an angle of incidence between 10 and 50 degrees with respect to the mirror normal. The absorption can be increased by choosing a wavelength for which the absorption cross-section of carbon is higher. Generally speaking the absorption increases both for lower wavelengths, e.g. lower than 780 nm and wavelengths in the IR regime, that is optical radiation with a wavelength larger than 1 micrometer. As is indicated by arrows in FIG. 6, at the position of the contamination a significant drop in reflectivity is measured. In FIG. 6 this occurs at x=9 mm and x=13 mm, as indicated by the arrows. Furthermore, in FIG. 6 the difference in relative reflectivity for different values of the contamination layer thickness is clearly visible.

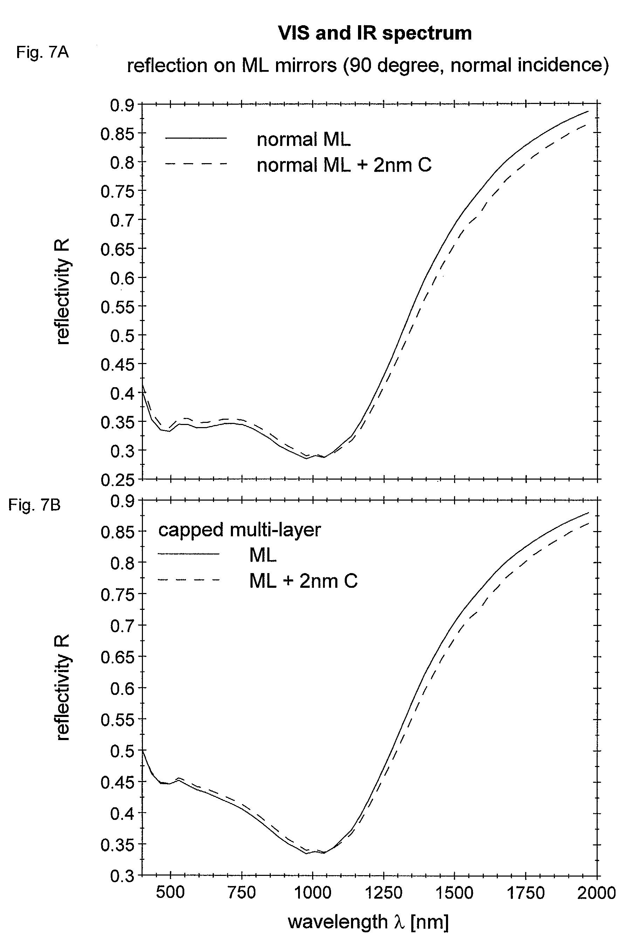

FIG. 7A shows the results of a simulation of the reflectivity (normal incidence) versus the wavelength of light for an uncapped Mo-Si multi-layer mirror, that is a multi-layer mirror with a surface layer similar to the other layers. FIG. 7B shows results of a simulation of the reflectivity (normal incidence) versus the wavelength of light for a capped Mo-Si multi-layer mirror (i.e. with a surface layer of a material different than the other layers in the mirror, in this example the surface layer is made of Ru).

The simulation of FIG. 7A was performed for a multi-layer mirror with a Si substrate on which 40 sets of alternately a 4.4 nm Si-layer and a 2.5 nm Mo were deposited. In FIG. 7B the multi-layer mirror was supposed to have a Si substrate on which 40 sets of alternately a 4.4 nm Si-layer and a 2.5 nm Mo layer were deposited. At the surface a set, also referred to as the cap, of a 1.5. nm Ru layer on a 2.0 nm Mo layer was supposed. In the simulations of FIGs. 7A and 7B, the contamination was supposed to be a 2 nm layer of carbon.

For both the uncapped and the capped multi-layer mirror, simulations are shown with and without a carbon contamination layer. As is shown in FIG. 7A with the dashed line, even a very thin layer of carbon, in this example a 2 nm thick layer of carbon, already significantly changes the spectrum of the uncapped mirror compared to the uncontaminated surface depicted with line. FIG. 7B shows a similar behaviour for a capped mirror with the dashed line indicating a mirror with contamination and the solid line indicating a clean mirror surface.

It is found from these simulations that a method or device according to the invention using optical radiation having a wavelength in the infrared range, especially between 1 and 2 micron and in particular between 1.2 and 1.7 µm, provides the highest sensitivity, i.e. largest modifications of the reflectivity, as may be derived from FIGs. 7A and 7B. Figs. 7A and 7B further show that for wavelengths between 0,5 and 1 micron, the reflectivity of a multi-layer mirror with carbon containing contamination is higher than the reflectivity of a multi-layer mirror with a clean surface. Without being bound to theory, the increase in reflectivity is ascribed to interference and standing wave effects

Fig. 8A shows the result of a simulation performed for a multi-layer mirror similar to the mirror used in the simulation of FIG. 7A contaminated with carbon layers of respectively 0,1,2,5, 10 and 20 nanometres thickness. Fig. 8B shows the result of a simulation performed for a multi-layer mirror similar to the mirror used in the simulation of FIG. 7A contaminated with silicon-oxide layers of respectively 1,2,5 and 10 nanometres thickness. As is shown in FIG. 8A, growth of a thin layer of carbon-containing materials can be detected accurately with optical radiation between 0 and 150 nm, especially around 50 nm and 120 nm, since for those ranges of wavelengths the growth of thin layers has a large effect on the reflectivity. For example, EUV radiation of 13.5 nm can be used which is in general already used in the beam of an EUV lithographic projection apparatus. As can be derived from FIG. 8B growth of thin layers of silicon (di)oxide containing material can be detected accurately by means of radiation between 50 nmand 150 nm and in particular for radiation between 100 and 120 nm wavelength. Thus, carbon containing materials and silicondioxide containing materials can be distinguished using different wavelengths, for example 10-70 nm for carbon containing materials and 70-150 nm for silicon(di)oxide,

From the radiation from the surface, for example the concentrations of materials in the contamination layer may be determined, such as concentrations of carbon containing materials and siliconoxide containing materials. As can be derived from the graphs, carbon containing materials and siliconoxide containing materials have different reflective properties, such as for example relative intensity or polarisation. Hence, the radiation reflected by the surface is a combination of those properties. Thus, by comparing the reflected radiation with reference values, the relative contribution of those materials to the reflected radiation can be determined and hence the concentration of those materials in the contamination.

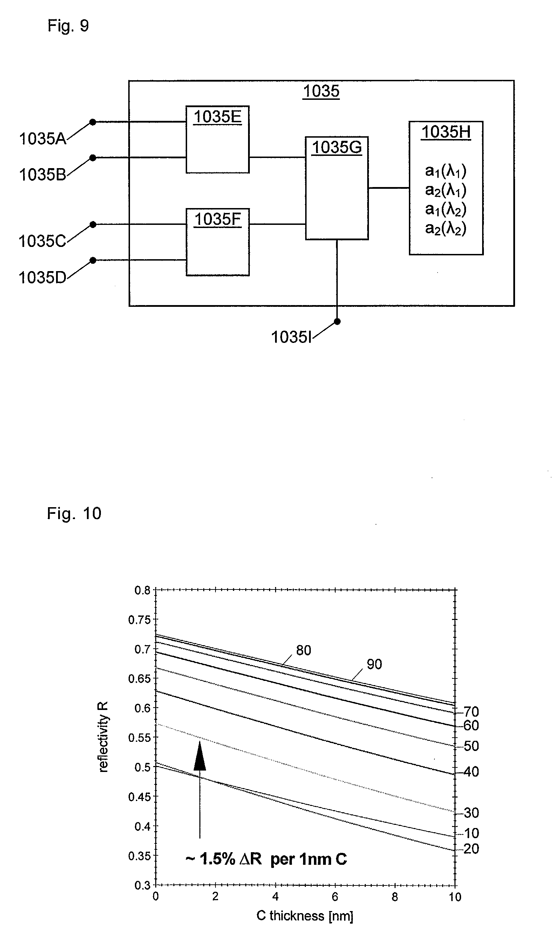

FIG. 9 shows an example of a section 1035 of a processor device 103 of the examples of FIGs. 2-4, suitable for performing such a method. The section 1035 has inputs 1035A-1035D connected to ratio determining devices 1035E,1035F. The ratio determining device 1035E,1035F are connected to a calculator device 1035G which is further connected to a memory 1035H . The calculator device 1035G has an output 1035I at which signals representing the established concentrations of the respective materials can be outputted.

At input 1035A, a signal corresponding to the intensity $I_{in}(\lambda_1)$ of the radiation transmitted by the transmitter device 101 at a first wavelength $\lambda_1$ is presented. At input 1035B, a signal corresponding to the intensity $I_{out}(\lambda_1)$ of the radiation received by the receiver device 102 at a first wavelength $\lambda_1$ is presented. At input 1035C, a signal corresponding to the intensity $I_{in}(\lambda_2)$ of the radiation transmitted by the transmitter device 101 at a second wavelength $\lambda_2$ is presented. At input 1035D, a signal corresponding to the intensity $I_{out}(\lambda_2)$ of the radiation received by the receiver device 102 at the second wavelength $\lambda_2$ is presented.

The ratio determining devices 1035E, 1035F each determine the ratio R of the transmitted intensity and received intensity for the specific wavelength, i.e. device 1035E determines the ratio $R(\lambda_1)$ at $\lambda_1$ and device 1035F determines the ratio $R(\lambda_2)$ at $\lambda_2$. The ratios $R(\lambda_1)$, $R(\lambda_2)$ are transmitted to the calculator device 1035G which derives the concentrations from said ratios and values $a_1(\lambda_1)$, $a_2(\lambda_1)$, $a_1(\lambda_2)$, $a_2(\lambda_2)$ which are stored in the memory 1035H. Values $a_1(\lambda_1)$ and $a_1(\lambda_2)$ represent the relative reflectivities at $\lambda_1$ and $\lambda_2$ for carbon and values $a_2(\lambda_1)$ and $a_2(\lambda_2)$ represent said relative reflectivities for silicon-oxide. Supposing that the mirror without contamination reflects all projected radiation, the calculator device can for example calculate the concentrations from the following equations:

$$R(\lambda_1) = c_{carbon}\alpha_1\,(\lambda_1) + c_{silicon\text{-}oxide}\alpha_2(\lambda_1) \tag{1}$$

$$R(\lambda_2) = c_{carbon}\,\alpha_1\,(\lambda_2) + c_{silicon\text{-}oxide}\alpha_2\,(\lambda_2) \tag{2},$$

in which equations c represents the concentration of the respective material. However, other calculations may likewise be performed by the calculator device to determine one or more properties of the contamination. The result of the calculation is thereafter outputted at the output 1035I of the section 1035.

Determination of the concentration can likewise be based on different properties of the reflected radiation such as the ratio of transmitted and received radiation for two or more different wavelengths, angles of incidence, polarisation, phase shifts, coherency or otherwise.

The angle of incidence of the radiation from the radiation transmitter device may be any angle suitable for the specific application. It is found that for electro-magnetic radiation of a fixed wavelength, in particular in the infrared, the reflectivity decreases substantially linear with the carbon thickness, as is illustrated in FIG. 10 for most angles of incidence. FIG. 10 shows results of a simulation of the reflectivity as a function of carbon thickness for a capped multilayer mirror similar to the one used in the simulation of FIG. 7B for various angles of incidence. The reference numbers in FIG. 10 indicate the angle of incidence of the radiation for the respective line. In the simulation of FIG. 10, the light was supposed to have a wavelength of 1530 nm. As can be derived from FIG. 10, the highest sensitivity in a method according to the invention of about 3% change of the measurement signal $\Delta R/R$ per 1 nm C is found at angles between 20 an 40 degrees of the radiation incident on the surface.

A method or device according to the invention may be used in any stage of operation of a lithographic projection apparatus. For example, a method or device according to the invention may be used to measure contamination on one or more components in the projection apparatus during cleaning of at least a part of the components. Thus, a controllable cleaning can be obtained and for example removal of too much material can be prevented. Such cleaning may be of any suitable type, such as for example the European patent application 02080488.6 or otherwise. For example, a photon beam, electron beam or ion beam may be projected on the surface of the component which projects photons, electrons or ions with sufficient energy to remove at least a part of the contamination. The receiver may then receive radiation emitted from the surface (or the contamination on the surface) in response to the beam. The received radiation may for example comprise secondary particles, scattered or reflected particles or otherwise. One or more properties of the contamination may then be derived from one or more properties of the received radiation. For example, the transmitter may emit electrons to the surface which remove at least a part of the contamination. The receiver device may measure electrons (back) scattered or transmitted by the surface in response to the transmitted electrons. In such a case, the receiver device may measure charge and be implemented as a diode, measure currents, such as leakage currents from the surface to ground or magnetic fields generated by the electrons or otherwise. The properties of scattered or transmitted electrons, such as energies, are dependent inter alia on the thickness of the contamination and the materials present in the contamination. Properties of the contamination can thus be determined from the characteristics of the scattered or transmitted electrons.

In a measuring device or method according to the invention, the transmitted radiation and the received radiation may be any type of radiation suitable for the specific implementation. The radiation can for example be electromagnetic radiation (such as infrared, visible or ultraviolet radiation) or otherwise. Furthermore, the transmitter may transmit a different type radiation than is received by the receiver. For example the transmitter may emit an electron beam while the receiver receives electro-magnetic radiation resulting from excitations of the molecules on the surface caused by the electron beam. Likewise, the transmitter may emit electro-magnetic radiation of a certain wavelength and the receiver may received radiation of another wavelength, thus for example the fluorescence of the contamination can be measured. The radiation may be of a single wavelength or comprise a broad spectrum or a plurality of wavelengths. Furthermore, the invention may likewise be applied as a computer program product for performing steps of a method according to the invention when run on a programmable device, thus for example enabling a programmable device such as a general purpose computer, to perform the functions of the section 1035 of FIG. 9.

It should be noted that the above-mentioned embodiments illustrate rather than limit the invention, and that those skilled in the art will be able to design alternatives without departing from the scope of the appended claims. In the claims, any reference signs placed between parentheses shall not be construed as limiting the claim. The word 'comprising' does not exclude the presence of other elements or steps than those listed in a claim. Unless stated otherwise, the word 'a' is used as meaning 'one or more'. The mere fact that certain measures are recited in mutually different claims does not indicate that a combination of these measures cannot be used to advantage.

## Claims

1. A measuring device for measuring at least one property of contamination of a surface of a component in a lithographic projection apparatus, comprising;

   - ■ a radiation transmitter device for projecting projected radiation on at least a part of said surface;
   - ■ a radiation receiver device for receiving radiation from the component in response to the projected radiation; and
   - ■ a processor device communicatively connected to the radiation receiver device, for deriving at least one property of received radiation and determining at least one property of said contamination from said at least one property of received radiation.

2. A device as claimed claim 1, comprising:

   - ■ a first radiation receiver for receiving at least a part of the projected radiation; and
   - ■ a second radiation receiver for receiving said radiation from the component;

   wherein the processor device comprises:

- ■ means for comparing said part of the projected radiation with the radiation received from the component;
- ■ means for determining from the received radiation a relative property relative to said part of the projected radiation; and
- ■ means for determining from the relative property at least one property of said contamination.

**3.** A device as claimed in any one of the preceding claims, wherein the processor has means for determining at least one property of modulated radiation modulated by the contamination of the surface.

**4.** A device as claimed in any one of the preceding claims, wherein the processor has means for comparing at least one property of received radiation with at least one reference value related to the at least one contamination property.

**5.** A device as claimed in any one of the preceding claims, wherein the processor comprises:

- ■ means for determining a first property of the received radiation;
- ■ means for determining a second property of the received radiation; and
- ■ means for deriving from said first property of the received radiation and the second property of the received radiation at least one contamination property of said contamination.

**6.** A device as claimed in claim 5, wherein said processor comprises:

means for deriving a first contamination property and a second contamination property from the first and second property of the received radiation.

**7.** A device as claimed in any one of the preceding claims, wherein the contamination comprises at least one material which at least partially modulates the projected radiation, said at least one material being one of the group consisting of : carbon containing materials, silicon containing material, oxide containing materials, salt containing materials, refractory materials.

**8.** A device as claimed in any one of the preceding claims, wherein said at least one property of the received radiation comprises at least one of the group consisting of:

intensity, wavelength, angle of incidence, polarisation and phase-shift.

**9.** A device as claimed in any one of the preceding claims, wherein said at least one contamination property comprises at least one of the group consisting of: thickness, position, roughness and chemical composition.

**10.** A device as claimed in any one of the preceding claims, comprising a radiation receiver for receiving radiation reflected by the surface of said component.

**11.** A device as claimed in any one of the preceding claims, comprising a radiation receiver for receiving radiation transmitted through at least a part of the component.

**12.** A device as claimed in any one of the preceding claims, comprising a radiation transmitter for transmitting projected radiation through at least a part of the component

**13.** A device as claimed in any one of the preceding claims, wherein projected radiation or received radiation comprises electro-magnetic radiation.

**14.** A device as claimed in claim 13, wherein the electro-magnetic radiation comprises at least one of the group consisting of: optical radiation in the range of visible light to far infrared light, ultraviolet radiation, such as Deep Ultraviolet or Extreme Ultraviolet Radiation.

**15.** A device as claimed in any one of the preceding claims, comprising:

- ■ a radiation transmitter for generating radiation at said surface by means of the projected radiation, which generated radiation differs in at least one aspect from the projected radiation, which at least one aspect is one of the group consisting of: wavelength and radiation type; and

■ a radiation receiver for receiving the generated radiation.

16. A device as claimed in any one of the preceding claims, wherein projected radiation or received radiation comprises a particle beam, such as an ion beam or an electron beam.

17. A device as claimed in any one of the preceding claims, comprising a constant intensity radiation transmitter for projecting radiation with an intensity which is substantially constant in time.

18. A device as claimed in any one of claims 1-17, comprising a variable intensity radiation transmitter for projecting radiation with an intensity which varies in time.

19. A device as claimed in claim 18, wherein the device is a heterodyne device.

20. A device as claimed in any one of the preceding claims, wherein the radiation transmitter is part of a radiation system which is used in a lithographic projection apparatus for providing a projection beam of radiation and projecting a radiation pattern with the projection beam of radiation onto a target portion of a layer of radiation-sensitive material.

21. A device as claimed in any one of the preceding claim, wherein the radiation receiver can receive radiation from at least two different parts of the surface and the processor comprises means for determining a property of contamination for each of said different parts.

22. A device as claimed in claim 21, wherein the device is a scanning measuring device with a scanning radiation transmitter for consecutively projecting radiation on at least two different parts of the surface.

23. A device as claimed in any one of the preceding claims, wherein the component is part of an optical system of the lithographic projection apparatus, such as a mirror, a lens, a reticle or a detector.

24. A device as claimed in any one of the preceding claims, wherein the lithographic projection apparatus is a Deep Ultraviolet or an Extreme Ultraviolet lithographic projection apparatus.

25. A method for measuring at least one property of contamination of a surface of a component in a lithographic projection apparatus, comprising:

■ projecting radiation on at least a part of the surface;
■ receiving radiation from the component in response to said projecting radiation; and
■ deriving from the received radiation at least one property of said contamination.

26. A method as claimed in claim 25, wherein the method is performed during cleaning of at least a part of said surface.

27. A lithographic projection apparatus comprising:

■ a radiation system for providing a projection beam of radiation;
■ a support structure for supporting patterning means, the patterning means serving to pattern the projection beam according to a desired pattern;
■ a substrate table for holding a substrate;
■ a projection system for projecting the patterned beam onto a target portion of the substrate, and
■ a measuring device in any one of claims 1-24.

28. A device manufacturing method comprising the steps of:

■ providing a substrate that is at least partially covered by a layer of radiation-sensitive material;
■ providing a projection beam of radiation using a radiation system;
■ using patterning means to endow the projection beam with a pattern in its cross-section; and
■ projecting the patterned beam of radiation onto a target portion of the layer of radiation-sensitive material, and
■ applying a method as claimed in any one of claims 25-26 to at least a part of the radiation system to determine if a surface of said part is contaminated to a certain degree with carbon containing materials.

**29.** A computer program product comprising program code portions for performing steps of a method as claimed in any one of the claims 25-26 when run on a programmable device.

Fig. 1

Fig. 2

Fig. 3

Fig. 4

Fig. 5

Fig. 6

**VIS and IR spectrum**

Fig. 7A

reflection on ML mirrors (90 degree, normal incidence)

Fig. 7B

EP 1 452 851 A1

Fig. 8A

Fig. 8B

Fig. 9

Fig. 10

**European Patent Office**

**EUROPEAN SEARCH REPORT**

Application Number

EP 04 07 5557

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | EP 0 874 283 A (NIPPON KOGAKU KK) 28 October 1998 (1998-10-28) * column 9, line 10 - line 31; figure 1 * * column 13, line 53 - column 14, line 49; figure 11 * * claim 8 * | 1-29 | G01N21/15 G01M11/00 G03F7/20 |
| X | US 2002/134947 A1 (VAN SCHAIK WILLEM) 26 September 2002 (2002-09-26) * page 3, paragraph 24 - page 4, paragraph 40 * * figures 1,2 * * column 5, paragraph 69 - column 6, paragraph 72 * | 1-29 | |
| X | US 6 392 738 B1 (KLAASSEN FRANCISCUS A G ET AL) 21 May 2002 (2002-05-21) * claim 1 * | 1-29 | |
| A | US 2002/145808 A1 (BINGEL ULRICH ET AL) 10 October 2002 (2002-10-10) * page 2, paragraph 19 - paragraph 21 * | 1-29 | TECHNICAL FIELDS SEARCHED (Int.Cl.7) G01N G01M G03F |
| A | US 6 427 703 B1 (SOMEKH SASSON) 6 August 2002 (2002-08-06) * column 1, line 61 - column 3, line 10 * | 1-29 | |
| A | US 2002/083409 A1 (HAMM UWE W) 27 June 2002 (2002-06-27) * page 2, paragraph 21 - paragraph 23 * | 1-29 | |

The present search report has been drawn up for all claims

| Place of search | Date of completion of the search | Examiner |
|---|---|---|
| MUNICH | 21 April 2004 | Consalvo, D |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**                    EP 04 07 5557

This annex lists the patent family members relating to the patent documents cited in  the above-mentioned European search report.
The members are as contained in the European Patent Office EDP file on
The European Patent Office is in no way liable for these particulars which are merely  given for the purpose of information.

21-04-2004

| Patent document cited in search report | | Publication date | Patent family member(s) | | Publication date |
|---|---|---|---|---|---|
| EP 0874283 | A | 28-10-1998 | JP | 10303097 A | 13-11-1998 |
| | | | JP | 10335235 A | 18-12-1998 |
| | | | JP | 10335236 A | 18-12-1998 |
| | | | DE | 69817663 D1 | 09-10-2003 |
| | | | EP | 0874283 A2 | 28-10-1998 |
| | | | US | 6268904 B1 | 31-07-2001 |
| | | | US | 2001030740 A1 | 18-10-2001 |
| US 2002134947 | A1 | 26-09-2002 | EP | 1220038 A1 | 03-07-2002 |
| | | | JP | 2002270501 A | 20-09-2002 |
| US 6392738 | B1 | 21-05-2002 | EP | 1093022 A2 | 18-04-2001 |
| | | | JP | 2001144013 A | 25-05-2001 |
| | | | TW | 484039 B | 21-04-2002 |
| US 2002145808 | A1 | 10-10-2002 | DE | 10109031 A1 | 05-09-2002 |
| | | | EP | 1235110 A2 | 28-08-2002 |
| | | | JP | 2002270502 A | 20-09-2002 |
| US 6427703 | B1 | 06-08-2002 | US | 6394109 B1 | 28-05-2002 |
| | | | EP | 1045422 A2 | 18-10-2000 |
| | | | JP | 2000353488 A | 19-12-2000 |
| | | | TW | 471003 B | 01-01-2002 |
| US 2002083409 | A1 | 27-06-2002 | DE | 10061248 A1 | 27-06-2002 |
| | | | EP | 1213617 A1 | 12-06-2002 |
| | | | JP | 2002261001 A | 13-09-2002 |

EPO FORM P0459

For more details about this annex : see Official Journal of the European Patent Office, No. 12/82